# EUROPÄISCHE PATENTSCHRIFT

(11) **EP 1 299 914 B1**
(45) Veröffentlichungstag und Bekanntmachung des Hinweises auf die Patenterteilung: **02.04.2008**
(21) Anmeldenummer: 01953838.8
(22) Anmeldetag: 03.07.2001
(51) Int. Cl.: H01L 29/775, H01L 21/335, H01L 29/423, H01L 51/00, H01L 51/05

(54) **FELDEFFEKTTRANSISTOR**
FIELD EFFECT TRANSISTOR
TRANSISTOR A EFFET DE CHAMP

(30) Priorität: 04.07.2000 DE 10032414; 04.07.2000 DE 10032370
(43) Veröffentlichungstag der Anmeldung: 09.04.2003
(73) Patentinhaber: Qimonda AG, 81739 München (DE)
(72) Erfinder: LUYKEN, Richard, Johannes, 81825 München (DE); SCHLÖSSER, Till, 01109 Dresden (DE); HANEDER, Thomas, Peter, 85221 Dachau (DE); HÖNLEIN, Wolfgang, 82008 Unterhaching (DE); KREUPL, Franz, 80802 München (DE)
(74) Vertreter: Viering, Jentschura & Partner
(86) Internationale Anmeldenummer: PCT/DE2001/002451
(87) Internationale Veröffentlichungsnummer: WO 2002/003482

(56) Entgegenhaltungen:
- WO-A-00/51186
- WO-A-99/04440
- SHEA H R ET AL: "Manipulation of Carbon Nanotubes and Properties of Nanotube Field-Effect Transistors and Rings" MICROELECTRONIC ENGINEERING, ELSEVIER PUBLISHERS BV., AMSTERDAM, NL, Bd. 46, Nr. 1-4, Mai 1999 (1999-05), Seiten 101-104, XP004170678 ISSN: 0167-9317

## Beschreibung

Die Erfindung betrifft einen Feldeffekttransistor.

Aus [1] sind eine Vielzahl unterschiedlicher Feldeffekttransistoren bekannt.

Ein Beispiel eines solchen Feldeffekttransistors ist der sogenannte MOS-Feldeffekttransistor.

Ein MOS-Feldeffekttransistor weist gemäß heutiger Technologie noch eine Chipfläche von mindestens ungefähr 0,8 µm² bis 1,5 µm² auf.

Weiterhin sind Grundlagen über sogenannte Carbon-Nanoröhren, die im weiteren als Kohlenstoff-Nanoröhren bezeichnet werden, aus [2] und [4] bekannt.

Ein Verfahren zum Herstellen von Kohlenstoff-Nanoröhren mittels Aufwachsen derselben auf einem Substrat, ist aus [3] bekannt.

Ein weiteres Verfahren zum Herstellen von Kohlenstoff-Nanoröhren durch Abscheiden der Kohlenstoff-Nanoröhren aus der Gasphase ist in [4] beschrieben.

Weiterhin ist aus [5] ein Verfahren bekannt, bei dem eine elektrisch halbleitende Kohlenstoff-Nanoröhre oder eine metallisch leitende Kohlenstoff-Nanoröhre mittels Dotierung von Bor-Atomen und Stickstoff-Atomen umgewandelt wird in eine Bor-Nitrid-Nanoröhre, die elektrisch isolierend wirken.

Weiterhin ist aus [6] ein Feldeffekttransistor mit einer Kohlenstoff-Nanoröhre bekannt, die zwei Goldelektroden miteinander über ein Siliziumdioxid-Substrat elektrisch steuerbar koppelt. In diesem Fall bilden die Goldelektroden den Source-Bereich bzw. den Drain-Bereich des Feldeffekttransistors und der gesteuerte Kanalbereich des Feldeffekttransistors wird von der Kohlenstoff-Nanoröhre gebildet. Über eine sich unterhalb der Siliziumdioxid-Schicht befindenden Silizium-Schicht, die als Gate-Bereich des Feldeffekttransistors verwendet wird, wird die den Kanalbereich bildende Kohlenstoff-Nanoröhre in ihren elektrischen Eigenschaften, insbesondere in ihrer elektrischen Leitfähigkeit gesteuert.

Aus [7] ist ferner ein Verfahren zum Herstellen eines Silizium-Nanodrahts bekannt.

Aus [9] ist ein Feldeffekttransistor mit einem SiliziumSubstrat als Gate, und einer darüber liegenden Siliziumdioxidschicht als Gateisolator, und zwei auf der Siliziumdioxidschicht aufgebrachten Goldelektroden als Source und Drain bekannt, bei dem eine Kohlenstoffnanoröhre, die den Kanalbereich des Feldeffekttransistors bildet, auf den zwei Goldelektroden und dem Bereich der Siliziumdioxidschicht, der sich zwischen den beiden Goldelektroden befindet, aufgebracht ist.

Dokument [10] beschreibt ein auf Fibern basierendes mikroelektronisches Netzwerk, welches von molekularen Wiedererkennungs-Eigenschaften Gebrauch macht.

Dokument [11] beschreibt einen komplementären Nanoschalter, welcher eine elektrisch leitende Nanoröhre, und eine Gate-Struktur mit einer weiteren Nanoröhre, und Barrierematerial, das sich zwischen den beiden Nanoröhren befindet, enthält, wobei das Barrierematerial eine bestimmte Elektronenaffinität aufweist, so dass in der leitenden Nanoröhre eine Elektronenverarmung stattfinden kann.

Somit liegt der Erfindung das Problem zugrunde, einen Feldeffekttransistor mit einem gegenüber den bekannten Feldeffekttransistoren geringerem Flächenbedarf anzugeben.

Ein Feldeffekttransistor gemäß Anspruch 1 weist einen Nanodraht auf, der einen Source-Bereich, einen Kanalbereich und einen Drain-Bereich des Feldeffekttransistors bildet, wobei der Nanodraht ein halbleitender und/oder ein metallisch leitender Nanodraht ist. Weiterhin weist der Feldeffekttransistor mindestens eine Nanoröhre auf, die einen Gate-Bereich des Feldeffekttransistors bildet, wobei die Nanoröhre eine halbleitende und/ode, eine metallisch leitende Nanoröhre ist. Der Nanodraht und ein Ende der Nanoröhre sind derart in einem Abstand voneinander angeordnet oder derart eingerichtet, dass im wesentlichen kein Tunnelstrom zwischen dem Nanodraht und der Nanoröhre möglich ist und dass mittels eines Feldeffekts durch Anlegen einer elektrischen Spannung an die Nanoröhre die Leitfähigkeit des Kanalbereichs des Nanodrahts steuerbar ist.

Der Feldeffekttransistor weist als Nanodraht gemäß einer Ausgestaltung der Erfindung eine erste Nanoröhre auf, die einen Source-Bereich, einen Kanalbereich und einen Drain-Bereich des Feldeffekttransistors bildet. Die erste Nanoröhre ist eine halbleitende und/oder eine metallisch leitende Nanoröhre. Weiterhin wird gemäß dieser Ausgestaltung der Erfindung die den Gate-Bereich bildende Nanoröhre von einer zweiten Nanoröhre gebildet, wobei die zweite Nanoröhre eine halbleitende und/oder eine metallisch leitende Nanoröhre ist. Die erste Nanoröhre und die zweite Nanoröhre sind in einem Abstand voneinander angeordnet derart, dass im wesentlichen kein Tunnelstrom zwischen den Nanoröhren möglich ist und dass mittels eines Feldeffekts durch Anlegen einer elektrischen Spannung an die zweite Nanoröhre die Leitfähigkeit des Kanalbereichs der ersten Nanoröhre steuerbar ist.

Da der Feldeffekttransistor im wesentlichen aus Nanoröhren gebildet wird ist somit ein Transistor mit gegenüber den bekannten Feldeffekttransistoren erheblich geringerem Flächenverbrauch geschaffen.

Weiterhin ist ein Schaltvorgang zwischen zwei Zuständen des Feldeffekttransistors mit erheblich verringerter Verlustleistung möglich, insbesondere aufgrund der im Vergleich zu herkömmlichen Feldeffekttransistoren erheblich geringeren Kapazität und der sehr guten elektrischen Leitfähigkeit insbesondere der Kohlenstoff-Nanoröhren.

Die Leitfähigkeit der ersten Nanoröhre wird aufgrund eines lokalen Anlegens eines elektrischen Potentials und somit eines elektrischen Feldes insbesondere in dem den Kanalbereich bildenden Abschnitt der ersten Nanoröhre variiert, wodurch die Funktionalität eines Feldeffekttransistors geschaffen worden ist.

Als Material für die erste Nanoröhre bzw. den Nanodraht kann jedes Material eingesetzt werden, solange die erste Nanoröhre bzw. der Nanodraht elektrisch halbleitende und/oder metallisch leitende Eigenschaften aufweist.

Außerdem können der Source-Bereich bzw. der Drain-Bereich sowie der Kanalbereich der ersten Nanoröhre bzw. des Nanodrahts dotiert werden. Auf diese Weise kann im Kanalbereich eine Potentialbarriere erzeugt werden, die zur Verringerung von Leckströmen im Ruhezustand führt. Vorzugsweise werden der Source-Bereich und der Drain-Bereich sowie der Kanalbereich so dotiert, dass sowohl zwischen dem Source-Bereich und dem Kanalbereich als auch zwischen dem Drain-Bereich und dem Kanalbereich ein pn-Übergang oder ein np-Übergang entsteht.

Es kann aber auch nur der Source-Bereich bzw. der Drain-Bereich oder der Kanalbereich dotiert werden.

Zur Verringerung von Leckströmen ist es im Fall von pn-Übergängen oder np-Übergängen ferner sinnvoll, kleine Bereich mit einer Größe von ungefähr 1 nm bis ungefähr 5 nm der Nanoröhre zwischen dem p-dotierten Bereich und dem n-dotierten Bereich undotiert zu lassen.

Anschaulich kann die Erfindung darin gesehen werden, dass in der Nähe des Kanalbereichs der ersten Nanoröhre bzw. des Nanodrahts eine zweite Nanoröhre als steuerndes Element derart angeordnet ist, dass die Leitfähigkeit der ersten Nanoröhre in dem den Kanalbereich bildenden Teil der ersten Nanoröhre bedarfsgerecht gesteuert werden kann.

Es ist anzumerken, dass gemäß einer Weiterbildung der Erfindung der Nanodraht und die den Gate-Bereich bildende Nanoröhre bzw. die beiden Nanoröhren sich nicht berühren, das heißt sie sind nicht in körperlichen Kontakt miteinander gebracht, sondern durch ein Dielektrikum, im einfachsten Fall durch Luft, einem Gas oder Vakuum, voneinander getrennt. Dennoch ist zu gewährleisten, dass mittels des Feldeffekts die Leitfähigkeit der ersten Nanoröhre ausreichend beeinflusst werden kann.

Alternativ kann das Dielektrikum auch durch ein zwischen die beiden Nanoröhren eingebrachtes, elektrisch nichtleitendes Gas gebildet werden.

Der kürzeste Abstand zwischen der ersten Nanoröhre und der zweiten, steuernden Nanoröhre wird in Abhängigkeit von einem maximal tolerierbaren Tunnelstrom zwischen den beiden Nanoröhren und der gewünschten Versorgungsspannung, mit der der Feldeffekttransistor betrieben wird, gewählt.

Beispielsweise ist bei zwei Kohlenstoff-Nanoröhren, wobei die zweite Nanoröhre im wesentlichen senkrecht zu der ersten Nanoröhre angeordnet ist, bei einem Durchmesser der beiden Nanoröhren von 1 nm bis 10 nm, der Abstand in einem Bereich von 0,5 nm bis 5 nm zu wählen. Anschaulich sind die beiden Nanoröhren in diesem Fall T-förmig zueinander angeordnet, so dass der Feldeffekttransistor eine T-förmige Struktur aufweist.

Weiterhin kann als Dielektrikum auch eine Isolatorschicht, d.h. eine Schicht aus elektrisch nichtleitendem Material verwendet werden, beispielsweise aus einem Oxidmaterial, z.B. aus Siliziumdioxid oder aus einem Nitridmaterial, z.B. aus Siliziumnitrid.

Es ist in diesem Zusammenhang lediglich erforderlich, dass zwischen den beiden Nanoröhren im wesentlichen kein Stromfluss möglich ist, maximal ein zu vernachlässigender Tunnelstrom.

Die Nanoröhren können als halbleitende und/oder metallisch leitende Kohlenstoff-Nanoröhren ausgestaltet sein.

Ferner können einwandige und/oder mehrwandige Nanoröhren, insbesondere Kohlenstoff-Nanoröhren verwendet werden.

Die zweite Nanoröhre kann drei Enden aufweisen, wobei an ein Ende eine elektrische Spannung anlegbar ist und die beiden weiteren Enden derart angeordnet sind, dass von ihnen aufgrund der angelegten elektrischen Spannung die Leitfähigkeit des Kanalbereichs der ersten Nanoröhre verändert werden können.

Durch diese Weiterbildung wird es möglich, den Kanalbereich, d.h. den aktiven Bereich, in dem die Leitfähigkeit verändert werden kann, zu vergrößern, wodurch auftretende Leckströme im gesperrten Zustand des Feldeffekttransistors erheblich reduziert werden.

Gemäß einer weiteren Ausgestaltung der Erfindung ist es vorgesehen, dass der Feldeffekttransistor zwei Gates aufweist, mit denen jeweils der Feldeffekttransistor geschaltet, d.h. die Leitfähigkeit in dem den Kanalbereich des Feldeffekttransistors bildenden Teil der ersten Nanoröhre verändert werden kann.

Durch diese Ausgestaltung wird die Fehleranfälligkeit und Störsicherheit verbessert.

In diesem Fall ist eine dritte Nanoröhre vorgesehen, die einen zweiten Gate-Bereich des Feldeffekttransistors bildet, wobei die dritte Nanoröhre eine halbleitende und/oder eine metallisch leitende Nanoröhre ist. Die erste Nanoröhre und die dritte Nanoröhre sind in einem Abstand voneinander angeordnet derart, dass kein Tunnelstrom zwischen dem Nanodraht und den Nanoröhren möglich ist und dass mittels eines Feldeffekts durch Anlegen einer elektrischen Spannung an die dritte Nanoröhre die Leitfähigkeit des Kanalbereichs des Nanodrahts bzw. der ersten Nanoröhre steuerbar ist.

Die zweite Nanoröhre und die dritte Nanoröhre können ferner elektrisch miteinander gekoppelt sein.

Allgemein kann grundsätzlich eine vorgebbare Anzahl weiterer Kohlenstoff-Nanoröhren auf weiteren Isolatorschichten als weitere Gates des Feldeffekttransistors aufgewachsen sein, wodurch eine einfache logische ODER-Anordnung mittels eines Feldeffekttransistors geschaffen wird.

Weiterhin kann jede Nanoröhre gemäß einer weiteren Ausgestaltung der Erfindung eine Mehrzahl oder sogar eine Vielzahl, anschaulich ein ganzes Bündel einzelner Nanoröhren aufweisen, wodurch die Stabilität und die Zuverlässigkeit des gebildeten Feldeffekttransistors weiter verbessert wird.

Die Enden der in dem Feldeffekttransistor verwendeten Nanoröhren können wahlweise offen oder geschlossen sein.

Gemäß einer weiteren Ausgestaltung der Erfindung weist der Feldeffekttransistor einen Nanodraht auf, der einen Source-Bereich, einen Kanalbereich und einen Drain-Bereich des Feldeffekttransistors bildet. Auf dem Nanodraht ist eine Nanoröhre aufgebracht, die einen isolierenden Bereich und einen halbleitenden Bereich oder einen metallisch leitenden Bereich aufweist. Der isolierende Bereich der Nanoröhre ist auf dem Kanalbereich des Nanodrahts derart aufgebracht, dass der isolierende Bereich der Nanoröhre einen Isolator des Feldeffekttransistors bildet. Ferner ist die Nanoröhre derart auf den Nanodraht aufgebracht, dass der halbleitende Bereich der Nanoröhre oder der metallisch leitende Bereich der Nanoröhre einen Gate-Bereich des Feldeffekttransistors bildet.

Der Nanodraht kann ein Silizium-Nanodraht sein.

Gemäß einer alternativen Ausgestaltung der Erfindung kann der Nanodraht eine weitere Nanoröhre sein, beispielsweise eine Kohlenstoff-Nanoröhre.

Ein Vorteil dieser Ausgestaltung ist insbesondere in der Kompaktheit der Lösung zu sehen, d.h. darin, dass beide Elemente des Feldeffekttransistors, sowohl das steuernde Element (Gate) als auch das gesteuerte Element (Kanal) durch jeweils eine Kohlenstoff-Nanoröhre gebildet wird mit den damit verbunden vorteilhaften Materialeigenschaften.

Die weitere Kohlenstoff-Nanoröhre kann mindestens einen halbleitenden Bereich sowie mindestens einen metallisch leitenden Bereich aufweisen, wobei der halbleitende Bereich zwischen zwei metallisch leitenden Bereichen angeordnet sein kann.

In diesem Fall bildet vorzugsweise der halbleitende Bereich der weiteren Kohlenstoff-Nanoröhre den Kanalbereich des Feldeffekttransistors und die zwei metallisch leitenden Bereiche den Source-Bereich bzw. den Drain-Bereich des Feldeffekttransistors.

Die Nanoröhre kann aus mehreren einzelnen Nanoröhren zusammengesetzt sein, beispielsweise aus einer elektrisch isolierenden Nanoröhre, gemäß einer Ausgestaltung der Erfindung einer Bor-Nitrid-Nanoröhre und einer oder mehreren halbleitenden oder metallisch leitenden Kohlenstoff-Nanoröhren.

Der isolierende Bereich der Nanoröhre kann durch eine Bor-Nitrid-Nanoröhre gebildet werden.

Allgemein ist in diesem Zusammenhang anzumerken, dass Kohlenstoff-Nanoröhren eine von den Röhrenparametern abhängige elektrische Leitfähigkeit aufweisen.

So gibt es abhängig von den Röhrenparametern elektrisch halbleitende Kohlenstoff-Nanoröhren und metallisch leitende Kohlenstoff-Nanoröhren.

Strukturell gleich aufgebaute Bor-Nitrid-Nanoröhren sind dagegen elektrisch isolierend, da diese eine energetische Bandlücke von 4 eV aufweisen.

Der halbleitende Bereich oder der metallisch leitende Bereich der Nanoröhre kann eine Kohlenstoff-Nanoröhre, d.h. eine halbleitende Kohlenstoff-Nanoröhre oder eine metallisch leitende Kohlenstoff-Nanoröhre sein.

Es ist somit möglich, beide üblicherweise entstehenden Arten von Kohlenstoff-Nanoröhren einzusetzen, womit die relativ aufwendige Überprüfung der elektrischen Eigenschaften der jeweils hergestellten Kohlenstoff-Nanoröhren sogar entfallen könnte, wenn dies gewünscht ist und beispielsweise die Transistorparameter nicht unbedingt bekannt sein müssen.

Es können im Rahmen der Erfindung sowohl einwandige als auch mehrwandige (Kohlenstoff-)Nanoröhren eingesetzt werden.

Ein weiterer Feldeffekttransistor weist einen Nanodraht auf, der einen Source-Bereich, einen Kanalbereich und einen Drain-Bereich des Feldeffekttransistors bildet. Auf dem Nanodraht ist mindestens eine elektrisch isolierende Nanoröhre, die einen Isolator des Feldeffekttransistors bildet, aufgebracht. Weiterhin weist der Feldeffekttransistor mindestens eine auf der isolierenden Nanoröhre aufgebrachten elektrisch halbleitende oder metallisch leitende Nanoröhre auf, die einen Gate-Bereich des Feldeffekttransistors bildet.

Anschaulich ist die elektrisch isolierende Nanoröhre bzw. der isolierende Bereich einer Nanoröhre derart auf den Nanodraht aufgebracht, dass es mittels der den Gate-Bereich bildenden halbleitenden oder metallisch leitenden Nanoröhre möglich ist mittels eines sich ausbildenden Feldeffekts in dem Kanalbereich des Feldeffekttransistors, d.h. in dem Nanodraht, die Dichte der elektrischen Ladungsträger zu steuern und somit den Feldeffekttransistor zwischen zwei Transistorzuständen, einem leitenden Transistorzustand und einem nicht leitenden Transistorzustand umzuschalten.

Die Steuerung der Kanalleitfähigkeit des erfindungsgemäßen Feldeffekttransistors erfolgt somit wie bei üblichen Feldeffekttransistoren mittels eines elektrischen Feldes durch eine an eine Gate-Elektrode angelegte elektrische Spannung, d.h. durch eine an den Gate-Bereich des Feldeffekttransistors angelegte elektrische Spannung.

Ein erheblicher Vorteil der Erfindung darin zu sehen, dass der angegebene Feldeffekttransistor sehr klein ist, d.h. seine Größe kann in einer Dimensionierung von bis zu 100 nm² und kleiner hergestellt werden.

Weiterhin ist aufgrund der Tatsache, dass ein einmolekularer, d.h. einstückiger Feldeffekttransistor aus Nanoröhren, allgemein aus einem Nanodraht und einer Nanoröhre gebildet wird, das elektronische Bauelement sehr einfach in Leiterbahnen einer elektrischen Schaltung integrierbar ist.

Ferner ist ein weiterer Vorteil der Erfindung in der Kompatibilität der Feldeffekttransistoren zu üblicherweise in Halbleiter-Schaltungen verwendetem Silizium-Material zu sehen.

Allgemein kann die Erfindung darin gesehen werden, dass auf einem Nanodraht, beispielsweise einer Kohlenstoff-Nanoröhre eine weitere Nanoröhre aufgebracht ist derart, dass das dadurch gebildete einstückige, d.h. einmolekulare Element als Feldeffekttransistor ein separates elektronisches, einmolekulares Bauelement darstellt.

Ausführungsbeispiele der Erfindung sind in den Figuren dargestellt und werden im Weiteren näher erläutert.

Es zeigen
- Figur 1: einen Querschnitt eines Feldeffekttransistors gemäß einem ersten Ausführungsbeispiel der Erfindung;
- Figur 2: einen Querschnitt eines Feldeffekttransistors gemäß einem zweiten Ausführungsbeispiel der Erfindung;
- Figur 3: einen Querschnitt eines Feldeffekttransistors gemäß einem dritten Ausführungsbeispiel der Erfindung;
- Figur 4: einen Querschnitt eines Feldeffekttransistors gemäß einem vierten Ausführungsbeispiel der Erfindung;
- Figur 5: einen Querschnitt eines Feldeffekttransistors gemäß einem fünften Ausführungsbeispiel der Erfindung; und
- Figur 6: einen Querschnitt eines Feldeffekttransistors gemäß einem sechsten Ausführungsbeispiel der Erfindung.
- Figuren 7A und 7B: einen Querschnitt eines Feldeffekttransistors gemäß einem siebten Ausführungsbeispiel der Erfindung, wobei in Figur 7A dessen Materialverlauf und in Figur 7B dessen Wandverlauf dargestellt ist;
- Figuren 8A und 8B: einen Querschnitt eines Feldeffekttransistors gemäß einem achten Ausführungsbeispiel der Erfindung, wobei in Figur 8A dessen Materialverlauf und in Figur 8B dessen Wandverlauf dargestellt ist;
- Figuren 9A und 9B: einen Querschnitt eines Feldeffekttransistors gemäß einem neunten Ausführungsbeispiel der Erfindung, wobei in Figur 9A dessen Materialverlauf und in Figur 9B dessen Wandverlauf dargestellt ist;
- Figuren 10A und 10B: einen Querschnitt eines Feldeffekttransistors gemäß einem zehnten Ausführungsbeispiel, wobei in Figur 10A dessen Materialverlauf und in Figur 10B dessen Wandverlauf dargestellt ist.

In den im Weiteren beschriebenen Ausführungsbeispielen sind gleiche Elemente eines Feldeffekttransistors teilweise mit identischen Bezugszeichen gekennzeichnet.

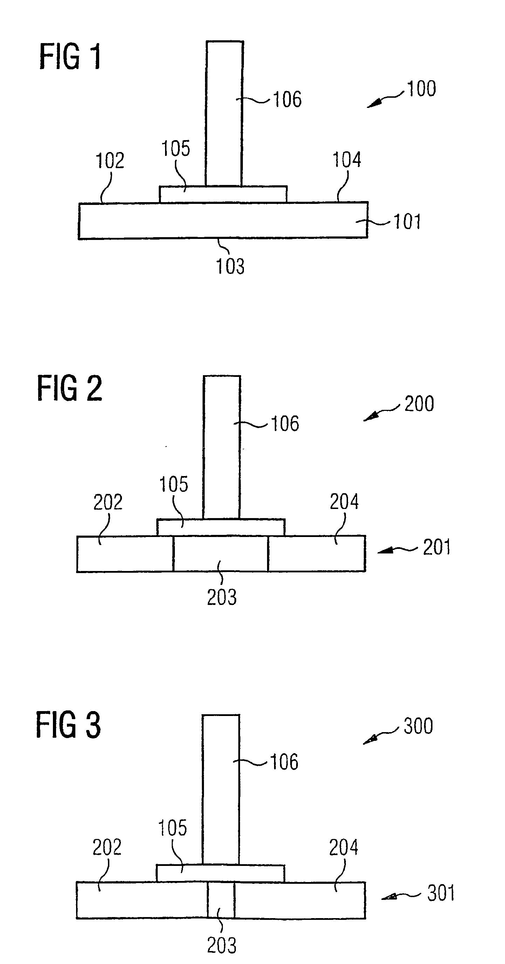

**Fig.1** zeigt einen Feldeffekttransistor 100 gemäß einem ersten Ausführungsbeispiel der Erfindung.

Der Feldeffekttransistor 100 weist eine elektrisch halbleitende oder metallisch leitende erste Kohlenstoff-Nanoröhre 101 auf der Länge von ungefähr bis zu 100 nm und einer Dicke von ungefähr 1 nm bis 10 nm.

Die erste Kohlenstoff-Nanoröhre 101 sowie alle im weiteren beschriebenen Kohlenstoff-Nanoröhren, auch die Kohlenstoff-Nanoröhren der weiteren Ausführungsbeispiele werden mittels eines Abscheideverfahrens aus der Gasphase, wie es in [2] beschrieben ist oder mittels Aufwachsens, wie es in [3] beschrieben ist, hergestellt.

Die erste Kohlenstoff-Nanoröhre 101 weist einen Source-Bereich 102, einen Kanalbereich 103 sowie einen Drain-Bereich 104 des Feldeffekttransistors 100 auf.

Auf der ersten Kohlenstoff-Nanoröhre 101 ist in dem Kanalbereich 103 eine Isolatorschicht 105 aus Siliziumnitrid oder Siliziumdioxid mittels eines CVD-Verfahrens oder eines Sputter-Verfahrens aufgebracht. Die Isolatorschicht 105 weist eine Dicke von ungefähr 2 nm bis 5 nm und eine Länge auf, die mindestens so groß ist wie die Länge des Kanalbereichs 103.

Im wesentlichen senkrecht zu der ersten Kohlenstoff-Nanoröhre 101 ist auf der Isolatorschicht eine zweite Kohlenstoff-Nanoröhre 106 aufgewachsen gemäß dem beschriebenen Verfahren.

Die zweite Kohlenstoff-Nanoröhre 106 weist eine Länge von ungefähr 10 nm und eine Dicke von ungefähr 1 nm bis 10 nm auf.

Es ist in diesem Zusammenhang anzumerken, dass es für die Funktionalität im wesentlichen unerheblich ist, wie lang oder wie dick eine Kohlenstoff-Nanoröhre 101, 106 ist. Sie können sich auch erheblich voneinander unterscheiden.

Ferner können die Kohlenstoff-Nanoröhren 101, 106 auch eine gebogene, d.h. gekrümmte Form aufweisen, so lange die oben beschriebene Funktionalität gewährleistet ist.

An die zweite Kohlenstoff-Nanoröhre 106, die als Gate des Feldeffekttransistors fungiert, wird eine elektrische Steuerspannung, die Gate-Spannung angelegt, wodurch ein elektrisches Feld erzeugt wird. Durch das elektrische Feld wird mittels eines Feldeffekts in dem Kanalbereich 103 das Potential verändert und damit die elektrische Leitfähigkeit der ersten Kohlenstoff-Nanoröhre 101 gesteuert.

**Fig.2** zeigt einen Feldeffekttransistor 200 gemäß einem zweiten Ausführungsbeispiel der Erfindung.

Der Feldeffekttransistor 200 unterscheidet sich von dem Feldeffekttransistor 100 gemäß dem ersten Ausführungsbeispiel im wesentlichen dadurch, dass die erste Kohlenstoff-Nanoröhre 201 gebildet wird durch drei, miteinander elektrisch leitend gekoppelte Kohlenstoff-Nanoröhren 202, 203, 204.

Eine erste Teil-Nanoröhre 202, die den Source-Bereich des Feldeffekttransistors 200 bildet, ist eine metallisch leitende Kohlenstoff-Nanoröhre.

Eine zweite Teil-Nanoröhre 203, die den Kanalbereich des Feldeffekttransistors 200 bildet, ist eine halbleitende Kohlenstoff-Nanoröhre.

Eine dritte Teil-Nanoröhre 204, die den Drain-Bereich des Feldeffekttransistors 200 bildet, ist wiederum eine metallisch leitende Kohlenstoff-Nanoröhre.

Gemäß dem zweiten Ausführungsbeispiel ist die zweite Teil-Nanoröhre 203 länger als die Dicke der zweiten Kohlenstoff-Nanoröhre 106, d.h. in anderen Worten, die zweite Teil-Nanoröhre 203 geht lateral über den Durchmesser der zweiten Kohlenstoff-Nanoröhre 106 hinaus.

**Fig.3** zeigt einen Feldeffekttransistor 300 gemäß einem dritten Ausführungsbeispiel der Erfindung.

Der Feldeffekttransistor 300 unterscheidet sich von dem Feldeffekttransistor 200 gemäß dem zweiten Ausführungsbeispiel im wesentlichen dadurch, dass die zweite Teil-Nanoröhre 203 kürzer ist als die Dicke der zweiten Kohlenstoff-Nanoröhre 106, d.h. in anderen Worten, die zweite Teil-Nanoröhre 203 ist die Ausdehnung des Kanalbereichs lateral geringer als der Durchmesser der zweiten Kohlenstoff-Nanoröhre 106.

Allgemein ist anzumerken, dass je länger der Kanalbereich, beispielsweise die zweite Teil-Nanoröhre 203 ist, desto geringer sind die Leckströme innerhalb des gesperrten Feldeffekttransistors. Andererseits ist der Einfluss der zweiten Kohlenstoff-Nanoröhre 106, die das Gate des Feldeffekttransistors bildet um so größer, je kürzer der Kanalbereich, beispielsweise die zweite Teil-Nanoröhre 203 ist.

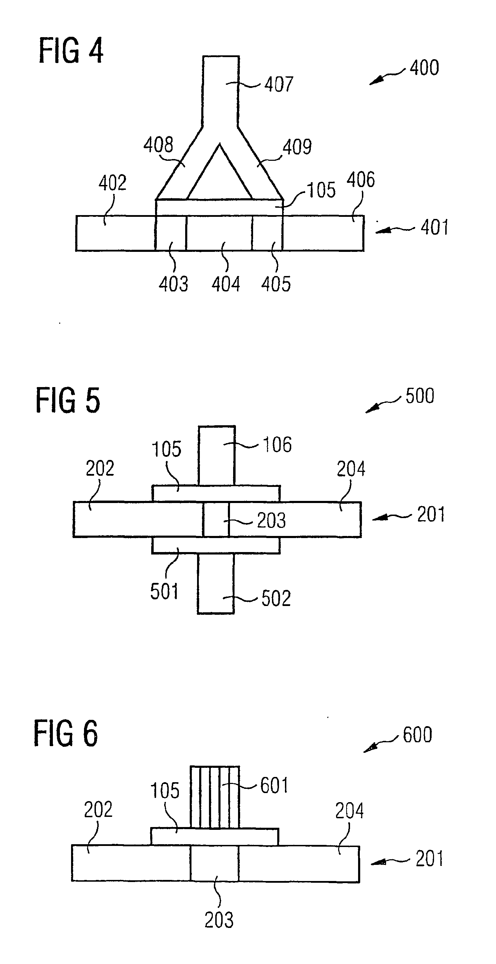

**Fig.4** zeigt einen Feldeffekttransistor 400 gemäß einem vierten Ausführungsbeispiel der Erfindung.

Die erste Kohlenstoff-Nanoröhre 401 des Feldeffekttransistors 400 weist insgesamt fünf Teil-Nanoröhren 402, 403, 404, 405, 406 auf.

Eine erste Teil-Nanoröhre 402, die den Source-Bereich des Feldeffekttransistors 400 bildet, ist eine metallisch leitende Kohlenstoff-Nanoröhre.

Der Kanalbereich des Feldeffekttransistors 400 wird von der zweiten Teil-Nanoröhre 403, der dritten Teil-Nanoröhre 404 und der vierten Teil-Nanoröhre 405 gebildet, wobei die zweite Teil-Nanoröhre 403 eine halbleitende, die dritte Teil-Nanoröhre 404 eine metallisch leitende und die vierte Teil-Nanoröhre 405 wiederum eine halbleitende Kohlenstoff-Nanoröhre ist.

Die fünfte.Teil-Nanoröhre 406, die den Drain-Bereich des Feldeffekttransistors 400 bildet, ist wiederum eine metallisch leitende Kohlenstoff-Nanoröhre.

Somit wird der Kanalbereich allgemein gebildet von Teil-Nanoröhren, wobei an jedem Ende des Kanalbereichs eine halbleitende Kohlenstoff-Nanoröhre angeordnet ist und dazwischen eine beliebige Anzahl metallisch leitender und halbleitender Kohlenstoff-Nanoröhren.

Gemäß diesem Ausführungsbeispiel ist die zweite Kohlenstoff-Nanoröhre 407 Ypsilon-förmig, d.h. die zweite Kohlenstoff-Nanoröhre 407 weist zwei Verzweigungen 408, 409, allgemein eine beliebige Anzahl von Verzweigungen auf, wobei die Verzweigungen 408, 409 auf der Isolatorschicht 105 über dem Bereich der zweiten Teil-Nanoröhre 403 und der vierten Teil-Nanoröhre 405 angeordnet, wodurch auf einfache Weise der Kanalbereich des Feldeffekttransistors 400 erweitert werden kann.

**Fig.5** zeigt einen Feldeffekttransistor 500 gemäß einem fünften Ausführungsbeispiel der Erfindung.

Der Feldeffekttransistor 500 unterscheidet sich von dem Feldeffekttransistor 300 gemäß dem dritten Ausführungsbeispiel im wesentlichen dadurch, dass auf der ersten Kohlenstoff-Nanoröhre in dessen Kanalbereich eine zweite Isolatorschicht 501 aufgebracht ist und eine dritte Kohlenstoff-Nanoröhre 502 auf dieser aufgewachsen ist.

Die dritte Kohlenstoff-Nanoröhre 502 ist mit der zweiten Kohlenstoff-Nanoröhre 106 elektrisch gekoppelt, so dass anschaulich ein Feldeffekttransistor 500 mit mehreren Gates gebildet wird.

Allgemein kann grundsätzlich eine vorgebbare Anzahl weiterer Kohlenstoff-Nanoröhren (nicht dargestellt) auf weiteren Isolatorschichten oder einer Isolatorschicht, die durchgängig um die erste Kohlenstoff-Nanoröhre herum aufgebracht ist, aufgewachsen sein.

**Fig.6** zeigt einen Feldeffekttransistor 600 gemäß einem sechsten Ausführungsbeispiel der Erfindung.

Der Feldeffekttransistor 600 unterscheidet sich von dem Feldeffekttransistor 300 gemäß dem dritten Ausführungsbeispiel im wesentlichen dadurch, dass die zweite Kohlenstoff-Nanoröhre gebildet wird durch eine Vielzahl, d.h. anschaulich ein Bündel von Kohlenstoff-Nanoröhren 601, die gemeinsam als Gate des Feldeffekttransistors 600 verwendet werden.

Den dargestellten Ausführungsbeispielen ist gemein, dass durch Anlegen einer elektrischen Spannung an den Gate-Bereich des jeweiligen Feldeffekttransistors der Stromfluss elektrischer Ladungsträger in dem Kanalbereich des gesteuerten Nanodrahts mittels des erzeugten elektrischen Feldes an dem Gate-Bereich mittels des auftretenden Feldeffekts gesteuert wird.

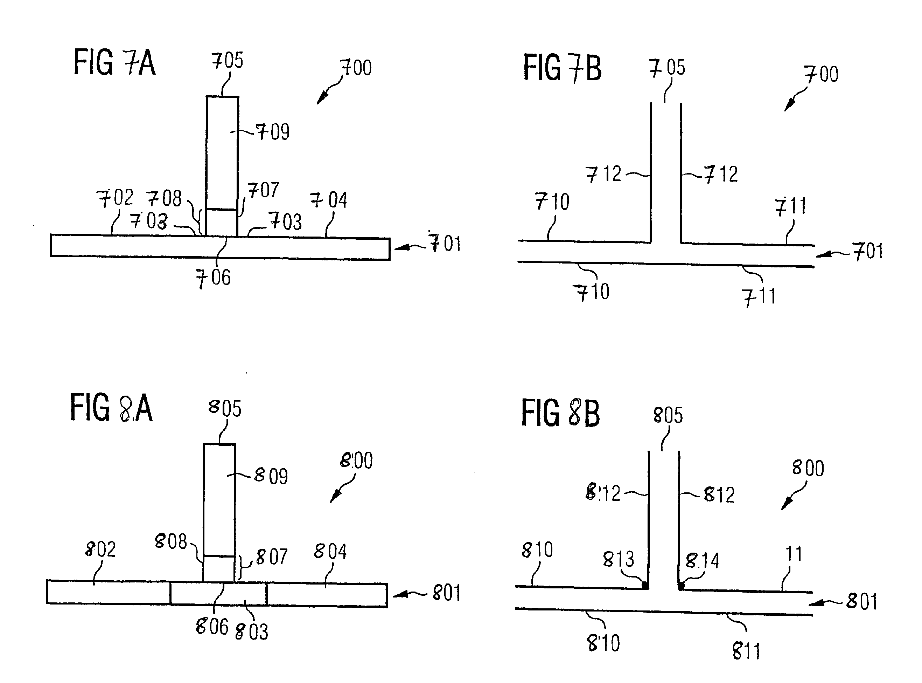

**Fig.7A** zeigt einen Querschnitt eines Feldeffekttransistors 700 gemäß einem siebten Ausführungsbeispiel der Erfindung.

Der Feldeffekttransistor 700 weist eine halbleitende erste Kohlenstoff-Nanoröhre 701 auf, die eine Source-Kanal-Drain-Struktur des Feldeffekttransistors 700 bildet, d.h. die halbleitende erste Kohlenstoff-Nanoröhre bildet einen Source-Bereich 702, einen Kanalbereich 703 sowie einen Drain-Bereich 704 des Feldeffekttransistors 700.

Die halbleitende erste Kohlenstoff-Nanoröhre 701 wird mittels des in [2] oder [3] beschriebenen Abscheideverfahrens hergestellt.

Auf der halbleitenden ersten Kohlenstoff-Nanoröhre 701 ist eine zweite Kohlenstoff-Nanoröhre 705 aufgebracht.

Gemäß diesem Ausführungsbeispiel wird die zweite Kohlenstoff-Nanoröhre 705 mittels des in [2] oder [3] beschriebenen Abscheideverfahrens aus der Gasphase auf der ersten Kohlenstoff-Nanoröhre 701 abgeschieden.

Alternativ können bereits hergestellte Nanoröhren mit drei Endbereichen, d.h. Anschlüssen, verwendet werden, wie sie beispielsweise in [8] beschrieben sind als T-förmige oder Y-förmige Nanoröhren.

Die nach dem Aufwachsen bzw. Abscheiden elektrisch metallisch leitende zweite Kohlenstoff-Nanoröhre 705 wird in einem vorgegebenen Bereich 708, der sich erstreckt von einem Kontaktbereich 706 zwischen der ersten Kohlenstoff-Nanoröhre 701 und der zweiten Kohlenstoff-Nanoröhre 705 entlang der zweiten Kohlenstoff-Nanoröhre 705 mit einer vorgegebenen Länge, umgewandelt in eine Bor-Nitrid-Nanoröhre 707.

Anders ausgedrückt bedeutet dies, dass die zweite Kohlenstoff-Nanoröhre 705 in einem vorgegebenen Bereich gemäß dem in [6] beschriebenen Verfahren mit Boratomen und Stickstoffatomen dotiert wird, so dass der vorgegebene Bereich 708 eine elektrisch isolierende Struktur bekommt.

Der restliche Bereich der zweiten Kohlenstoff-Nanoröhre 705 bleibt weiterhin eine elektrisch metallisch leitende oder halbleitende Kohlenstoff-Nanoröhre, die gemäß diesem Ausführungsbeispiel mit dem Bezugszeichen 709 bezeichnet wird.

Der mit den Bor-Atomen und den Stickstoff-Atomen dotierte, elektrisch isolierende Bereich 708 des Feldeffekttransistors 700 wirkt im Rahmen des gebildeten Feldeffekttransistors 700 als Isolator zwischen dem Kanalbereich 703, auf dem die zweite Kohlenstoff-Nanoröhre 705 aufgebracht ist, und dem als Gate-Bereich fungierenden weiterhin metallisch leitenden Bereich 709 der zweiten Kohlenstoff-Nanoröhre 705.

Auf diese Weise kann durch elektrisches Ansteuern des Feldeffekttransistors 700, insbesondere durch Anlegen einer elektrischen Spannung an den Gate-Bereich 709 der zweiten Kohlenstoff-Nanoröhre 705, die Ladungsdichte der elektrischen Ladungsträger in dem Kanalbereich 703 und damit die elektrische Leitfähigkeit des Kanalbereichs 703 des Feldeffekttransistors 700 gesteuert werden.

Somit ist ein Feldeffekttransistor gebildet, bei dem eine erste Kohlenstoff-Nanoröhre 701 in ihrem elektrischen Verhalten über eine zweite Kohlenstoff-Nanoröhre 705 durch Anlegen einer elektrischen Spannung an die zweite Kohlenstoff-Nanoröhre 705 gesteuert werden kann.

**Fig.7B** zeigt den zugehörigen Verlauf der Wände der ersten Kohlenstoff-Nanoröhre 701 bzw. der zweiten Kohlenstoff-Nanoröhre 705 des Feldeffekttransistors 700.

Wie **Fig.7B** zu entnehmen ist, ist die zweite Kohlenstoff-Nanoröhre 705 derart auf der ersten Kohlenstoff-Nanoröhre 701 aufgebracht, dass in dem Kontaktbereich 706 die Wände 710, 711 der ersten Kohlenstoff-Nanoröhre 701 unmittelbar mit der Wand 712 der zweiten Kohlenstoff-Nanoröhre 705 gekuppelt sind.

Es ist in diesem Zusammenhang anzumerken, dass gemäß allen Ausführungsbeispielen der Erfindung sowohl einwandige als auch mehrwandige Kohlenstoff-Nanoröhren verwendet werden können.

In **Fig.8A** ist ein Feldeffekttransistor 800 gemäß einem achten Ausführungsbeispiel der Erfindung dargestellt.

Der Feldeffekttransistor 800 weist eine erste Kohlenstoff-Nanoröhre 801 auf, die, in gleicher Weise wie die erste Kohlenstoff-Nanoröhre 701 des Feldeffekttransistors 700 gemäß dem siebten Ausführungsbeispiel die Source-Kanal-Drain-Struktur des Feldeffekttransistors 800 bildet.

Ein erster Bereich der ersten Kohlenstoff-Nanoröhre 801 ist ein Bereich einer elektrisch metallisch leitenden Kohlenstoff-Nanoröhre 802, die den Source-Bereich des Feldeffekttransistors 800 bildet.

Ein elektrisch halbleitender Kohlenstoff-Nanoröhren-Bereich 803 bildet den Kanalbereich 803 des Feldeffekttransistors 800.

Ein sich an dem Kanalbereich 803 anschließender metallisch leitender Kohlenstoff-Nanoröhren-Bereich 804 bildet den Drain-Bereich des Feldeffekttransistors 800.

In gleicher Weise wie gemäß dem siebten Ausführungsbeispiel ist auf der ersten Kohlenstoff-Nanoröhre 801 eine zweite Kohlenstoff-Nanoröhre 805 auf dem Kanalbereich 803 der ersten Kohlenstoff-Nanoröhre 801 aufgebracht.

Es bildet sich somit ein Kontaktbereich 806 zwischen der ersten Kohlenstoff-Nanoröhre 801 und der zweiten Kohlenstoff-Nanoröhre 805.

Die zweite Kohlenstoff-Nanoröhre 805 wird in einem Bereich 808 vorgegebener Größe mit Boratomen oder Stickstoffatomen dotiert, so dass ein isolierender Bereich 807 unmittelbar auf der ersten Kohlenstoff-Nanoröhre 801 gebildet wird.

Der restliche Bereich der zweiten Kohlenstoff-Nanoröhre 805 ist weiterhin elektrisch metallisch leitend und bildet den Gate-Bereich 809 des Feldeffekttransistors 800.

**Fig. 8B** zeigt den Wandverlauf des Feldeffekttransistors 800, bei dem wiederum gezeigt ist, dass die Wände 810, 811 der ersten Kohlenstoff-Nanoröhre 801 anschaulich eine Basis bildet, auf der die zweite Kohlenstoff-Nanoröhre 805 aufgebracht ist, und wobei die Wände 812 der zweiten Kohlenstoff-Nanoröhre 805 auf der ersten Kohlenstoff-Nanoröhre 801 unmittelbar aufgebracht sind, d.h. an Kontaktstellen 813, 814, der gemäß diesem Ausführungsbeispiel bei zylinderförmiger zweiter Kohlenstoff-Nanoröhre eine kreisförmige Struktur aufweist, gekuppelt ist.

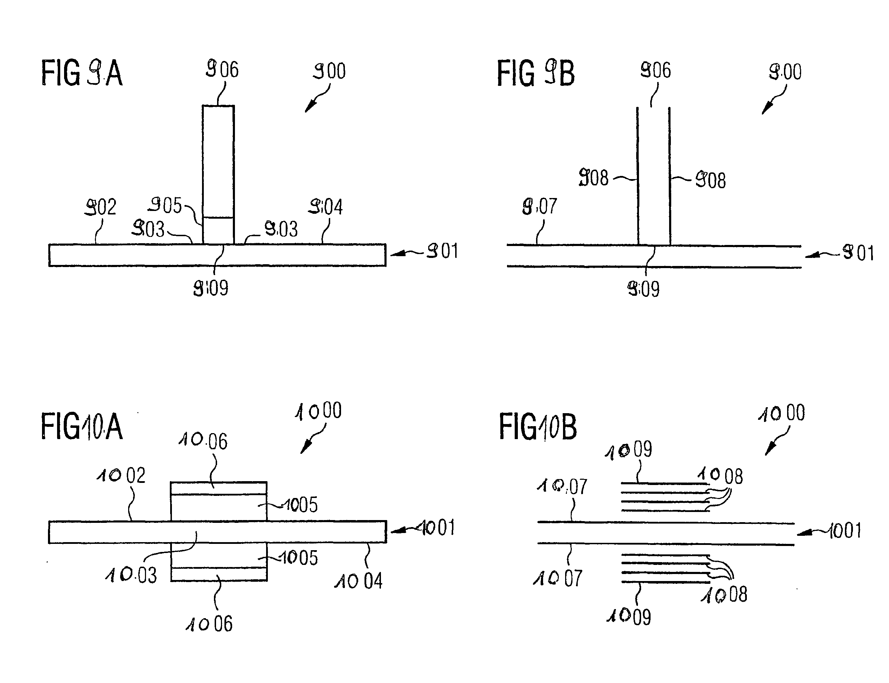

**Fig.9A** zeigt einen Feldeffekttransistor 900 gemäß einem neunten Ausführungsbeispiel der Erfindung.

Auf einem Silizium-Nanodraht 901, der die Source-Kanal-Drain-Struktur des Feldeffekttransistors 900 bildet, und der elektrisch halbleitend ist, ist in den Kanalbereich 903, der zwischen dem Source-Bereich 902 und dem Drain-Bereich 904 des Feldeffekttransistors 900 angeordnet ist, eine erste Kohlenstoff-Nanoröhre 905 als Bor-Nitrid-Nanoröhre aufgebracht, so dass ein Kontaktbereich 909 zwischen dem Silizium-Nanodraht 901 und der ersten Kohlenstoff-Nanoröhre 905 gebildet wird.

Auf der ersten Kohlenstoff-Nanoröhre 905 ist eine zweite Kohlenstoff-Nanoröhre 906 aufgebracht, d.h. angeschlossen, wobei die zweite Kohlenstoff-Nanoröhre 906 den Gate-Bereich des Feldeffekttransistors 900 bildet und als elektrisch metallisch leitende Kohlenstoff-Nanoröhre ausgestaltet ist.

**Fig.9B** zeigt den Wandverlauf des Feldeffekttransistors 900.

Wiederum ist auf dem Silizium-Nanodraht 901, d.h. auf dessen oberer Wand 907 der erste Kohlenstoff-Nanodraht 905 und der zweite Kohlenstoff-Nanodraht 906, die eine gemeinsame Einheit bilden, aufgebracht, so dass dessen Seitenwände 908 in dem Kontaktbereich 906 gekuppelt sind.

**Fig.10A** zeigt einen Feldeffekttransistor 1000 gemäß einem zehnten Ausführungsbeispiel.

Wiederum ist eine erste Kohlenstoff-Nanoröhre 1001, gemäß diesem Ausführungsbeispiel eine durchgängig halbleitende Kohlenstoff-Nanoröhre, alternativ auch ein halbleitender Silizium-Nanodraht oder eine wie gemäß dem achten Ausführungsbeispiel aus mehreren Kohlenstoff-Nanoröhren mit unterschiedlichen elektrischen Eigenschaften gebildete Source-Kanal-Drain-Struktur des Feldeffekttransistors 1000 vorgesehen.

Die erste Kohlenstoff-Nanoröhre 1001 bildet somit wiederum einen Source-Bereich 1002, einen Kanalbereich 1003 sowie einen Drain-Bereich 1004.

Auf dem Kanalbereich 1003 ist eine mehrwandige zweite Kohlenstoff-Nanoröhre 1005 aufgebracht, gemäß diesem Ausführungsbeispiel eine elektrisch isolierende Bor-Nitrid-Nanoröhre.

Die mehrwandige Bor-Nitrid-Nanoröhre 1005 dient als Isolator im Rahmen des Feldeffekttransistors 1000.

Auf der Bor-Nitrid-Nanoröhre 1005 ist eine weitere, elektrisch metallisch leitende Kohlenstoff-Nanoröhre 1006 aufgebracht, die als Gate des Feldeffekttransistors 1000 verwendet wird.

**Fig.10B** zeigt den zu dem Feldeffekttransistor 1000 korrespondierenden Wandverlauf, in der die Wände 1007 der ersten Kohlenstoff-Nanoröhre 1001, die Wände 1008 der mehrwandigen Bor-Nitrid-Nanoröhre 1005 und die Wände 1009 der zweiten Kohlenstoff-Nanoröhre 1006 dargestellt sind.

Die oben dargestellten Feldeffekttransistoren können ferner auch gebildet werden, indem der elektrische isolierend wirkende Bereich 708 der zweiten Kohlenstoff-Nanoröhre 705, 805, 906 lokal durch eine Bor-Nitrid-Nanoröhre ersetzt wird.

Weiterhin kann eine kontrollierte Gasphasenepitaxie unter Verwendung von Katalysatoren zum Aufwachsen der Bor-Nitrid-Nanoröhre bzw. der metallisch leitenden Kohlenstoff-Nanoröhre auf der entsprechenden Bor-Nitrid-Nanoröhre gemäß dem in [3] beschriebenen Verfahren erzeugt werden.

In einer weiteren alternativen Vorgehensweise können die einzelnen Elemente des Feldeffekttransistors unter Verwendung von Nano-Manipulatoren zusammengebaut werden.

Weiterhin ist es gemäß einer alternativen Ausgestaltung der Erfindung vorgesehen, auf dem ersten Nanodraht, d.h. beispielsweise der ersten Kohlenstoff-Nanoröhre in dem Kanalbereich des gebildeten Feldeffekttransistors gemäß dem in [3] beschriebenen Verfahren eine Kohlenstoff-Nanoröhre mit der Länge des gewünschten Bereichs 708 aufzuwachsen, diese gebildete Kohlenstoff-Nanoröhre mit Boratomen und Stickstoffatomen zu dotieren, so dass eine Bor-Nitrid-Nanoröhre entsteht, und auf dieser Bor-Nitrid-Nanoröhre die metallisch leitende Kohlenstoff-Nanoröhre aufzuwachsen.

In diesem Dokument sind folgende Veröffentlichungen zitiert:
[1] U. Tietze, Ch. Schenk, Halbleiterschaltungstechnik, 11. Auflage, Springer Verlag, ISBN 3-540-64192-0, S. 187 - 218, 1999.
[2] Z. F. Ren et al, Synthesis of Large Arrays of Well-Aligned Carbon Nanotubes on Glass, SIENCE, Volume 282. S. 1105 - 1107, November 1998
[3] Young Sang Suh und Yin Seong Lee, Highly-Ordered Two-Dimensional Carbon-Nanotubes Areas, Applied Physics Letters, Volume 75, Nr. 14, S. 2047-2049, Oktober 1991
[4] T. Dekker, Carbon-Nanotubes as Molecular Quantum Wires, Physics Today, S. 22-28, Mai 1999
[5] W. Han et al, Synthesis of Boron Nitride Nanotubes From Carbon Nanotubes by a substitution Reaction, Applied Physics Letters, Volume 73, Number 21, S. 3085 - 3087, November 1998
[6] R. Martel et al, Single- and Multi-Wall Carbon Nanotube Field-Effect Transistors, Applied Physics Letters, Volume 73, Number 17, S. 2447 - 2449, October 1998
[7] Sung-Wook Chung et al, Silicon nanowire devices, Applied Physics Letters, Vol. 76, No. 15, S. 2068 - 2070, 1999
[8] A.S. Vedeneev et al, Molecular-Scale Rectifying Diodes Based on Y-Junction Carbon Nanotubes, Proceedings of the IEDM Conference, Washington, 1999
[9] Shea, H.R. et. al., Manipulation of Carbon Nanotubes and Properties of Nanotube Field-Effect Transistors and Rings, Microelectronic Engineering, Elsevier Publishers BV., Amsterdam, NL, Bd. 46, Nr. 1-4, Mai 1999 (1999-05), Seiten 101-104, XP004170678 ISSN: 0167-9317
[10] WO 99/04440 A (Ben Joseph Gdalyahu; Technion Res. & Dev. Foundation (IL); Eichen Yoav) 28. Januar 1999
[11] WO 00/51186 A (Clawson Joseph Jr.) 31. August 2000

### Bezugszeichenliste

- 100: Feldeffekttransistor
- 101: Erste Kohlenstoff-Nanoröhre
- 102: Source-Bereich
- 103: Kanalbereich
- 104: Drain-Bereich
- 105: Isolatorschicht
- 106: Zweite Kohlenstoff-Nanoröhre

- 200: Feldeffekttransistor
- 201: Erste Kohlenstoff-Nanoröhre
- 202: Erste Teil-Nanoröhre
- 203: Zweite Teil-Nanoröhre
- 204: Dritte Teil-Nanoröhre

- 300: Feldeffekttransistor

- 400: Feldeffekttransistor
- 401: Erste Kohlenstoff-Nanoröhre
- 402: Erste Teil-Nanoröhre
- 403: Zweite Teil-Nanoröhre
- 404: Dritte Teil-Nanoröhre
- 405: Vierte Teil-Nanoröhre
- 406: Fünfte Teil-Nanoröhre
- 407: Zweite Kohlenstoff-Nanoröhre
- 408: Verzweigung
- 409: Verzweigung

- 500: Feldeffekttransistor
- 501: Zweite Isolatorschicht
- 502: Dritte Kohlenstoff-Nanoröhre

- 600: Feldeffekttransistor
- 601: Bündel Kohlenstoff-Nanoröhren

- 700: Feldeffekttransistor
- 701: Erste Kohlenstoff-Nanoröhre
- 702: Source-Bereich
- 703: Kanalbereich
- 704: Drain-Bereich
- 705: Zweite Kohlenstoff-Nanoröhre
- 706: Kontaktbereich
- 707: Bor-Nitrid-Nanoröhre
- 708: Vorgegebener Bereich
- 709: Bereich metallisch leitende oder halbleitende Kohlenstoff-Nanoröhre
- 710: Wand erste Kohlenstoff-Nanoröhre
- 711: Wand erste Kohlenstoff-Nanoröhre
- 712: Wand zweite Kohlenstoff-Nanoröhre

- 800: Feldeffekttransistor
- 801: Erste Kohlenstoff-Nanoröhre
- 802: Source-Bereich
- 803: Kanalbereich
- 804: Drain-Bereich
- 805: Zweite Kohlenstoff-Nanoröhre
- 806: Kontaktbereich
- 807: Bor-Nitrid-Nanoröhre
- 808: Vorgegebener Bereich
- 809: Bereich metallisch leitende oder halbleitende Kohlenstoff-Nanoröhre
- 810: Wand erste Kohlenstoff-Nanoröhre
- 811: Wand erste Kohlenstoff-Nanoröhre
- 812: Wand zweite Kohlenstoff-Nanoröhre
- 813: Kontaktstelle
- 814: Kontaktstelle

- 900: Feldeffekttransistor
- 901: Silizium-Nanodraht
- 902: Source-Bereich
- 903: Kanalbereich
- 904: Drain-Bereich
- 905: Bor-Nitrid-Nanoröhre
- 906: Zweite Kohlenstoff-Nanoröhre
- 907: Oberer Wand Silizium-Nanodraht
- 908: Seitenwand Kohlenstoff-Nanoröhre
- 909: Kontaktbereich

- 1000: Feldeffekttransistor
- 1001: Erste Kohlenstoff-Nanoröhre
- 1002: Source-Bereich
- 1003: Kanalbereich
- 1004: Drain-Bereich
- 1005: Mehrwandige zweite Kohlenstoff-Nanoröhre
- 1006: Metallisch leitende Kohlenstoff-Nanoröhre
- 1007: Wand erste Kohlenstoff-Nanoröhre
- 1008: Wand mehrwandige Bor-Nitrid-Nanoröhre
- 1009: Wand zweite Kohlenstoff-Nanoröhre

## Patentansprüche

1. Feldeffekttransistor (100),
• mit einem Nanodraht (101), der einen Source-Bereich (102), einen Kanalbereich (103) und einen Drain-Bereich (104) des Feldeffekttransistors (100) bildet, wobei der Nanodraht (101)ein halbleitender und/oder ein metallisch leitender Nanodraht ist,
• mit mindestens einer Nanoröhre (106), die einen Gate-Bereich des Feldeffekttransistors bildet, wobei die Nanoröhre eine halbleitende und/oder eine metallisch leitende Nanoröhre ist,
wobei
• ein Ende der Nanoröhre (106) derart nahe am Nanodraht (101) angeordnet ist, dass von diesem einen Ende mittels eines Feldeffekts durch Anlegen einer elektrischen Spannung an die Nanoröhre (106) die Leitfähigkeit des Kanalbereichs (103) des Nanodrahts (101) steuerbar ist.

2. Feldeffekttransistor (100) nach Anspruch 1,
• bei dem der Nanodraht (101) von einer ersten Nanoröhre (101) gebildet wird, und
• bei dem die Nanoröhre von einer zweiten Nanoröhre gebildet wird.

3. Feldeffekttransistor (100) nach Anspruch 2, bei dem die erste Nanoröhre (101) und/oder die zweite Nanoröhre (106) eine Kohlenstoff-Nanoröhre ist/sind.

4. Feldeffekttransistor (100) nach einem der Ansprüche 1 bis 3,
bei dem zwischen den Nanodraht (101) und der Nanoröhre (106) elektrisch nicht leitendes Gas eingebracht ist.

5. Feldeffekttransistor (100) nach einem der Ansprüche 2 bis 4, bei dem die erste Nanoröhre (101) und/oder die zweite Nanoröhre (106) mehrere Wände aufweist.

6. Feldeffekttransistor (100) nach einem der Ansprüche 2 bis 5,
bei dem zumindest auf dem Kanalbereich (103) der ersten Nanoröhre (101) eine Isolatorschicht (105) aufgebracht ist, und
bei dem auf der Isolatorschicht (105) die zweite Nanoröhre
aufgebracht ist.

7. Feldeffekttransistor (100) nach Anspruch 6, bei dem die Isolatorschicht (105) ein Oxidmaterial oder ein Nitridmaterial enthält.

8. Feldeffekttransistor (400) nach einem der Ansprüche 1 bis 7, bei dem die den Gate-Bereich des Feldeffekttransistors (400) bildende Nanoröhre (407) drei Enden aufweist, wobei an ein Ende eine elektrische Spannung anlegbar ist und die beiden weiteren Enden derart angeordnet sind, dass von ihnen aufgrund der angelegten elektrischen Spannung die Leitfähigkeit des Kanalbereichs (403, 404, 405) des Nanodrahts verändert werden können.

9. Feldeffekttransistor (500) nach einem der Ansprüche 1 bis 8,
• bei dem eine dritte Nanoröhre (502) vorgesehen ist, die einen zweiten Gate-Bereich des Feldeffekttransistors (500) bildet, wobei die dritte Nanoröhre (502) eine halbleitende und/oder eine metallisch leitende Nanoröhre ist, und
• wobei ein Ende der Nanoröhre (502) derart nahe am Nanodraht (201) angeordnet ist, dass von diesem einen Ende der Nanoröhre (502) mittels eines Feldeffekts durch Anlegen einer elektrischen Spannung an die dritte Nanoröhre (502) die Leitfähigkeit des Kanalbereichs (203) des Nanodrahts (201) steuerbar ist.

10. Feldeffekttransistor (500) nach einem der Ansprüche 1 bis 9, bei dem die den Gate-Bereich des Feldeffekttransistors bildende Nanoröhre (106) und die dritte Nanoröhre (502) miteinander elektrisch gekoppelt sind.

11. Feldeffekttransistor (600) nach einem der Ansprüche 1 bis 10,
bei dem zumindest eine der Nanoröhren (601) eine Vielzahl von Nanoröhren aufweist.

12. Feldeffekttransistor (700) nach Anspruch 1,
• bei dem die mindestens eine Nanoröhre (705) auf dem Nanodraht (701) aufgebracht ist und einen elektrisch isolierenden Bereich (708) und einen halbleitenden (709) Bereich oder einen metallisch leitenden Bereich (709) aufweist,
• wobei der isolierende Bereich (708) der Nanoröhre (705) auf dem Kanalbereich (703) des Nanodrahts (701) aufgebracht ist derart, dass der isolierende Bereich (708) der Nanoröhre einen Isolator des Feldeffekttransistors (700) bildet, und
• dass der halbleitende Bereich (709) oder der metallisch leitende Bereich (709) der Nanoröhre (705) einen Gate-Bereich des Feldeffekttransistors (700) bildet.

13. Feldeffekttransistor (900) nach Anspruch 12,
• mit einem Nanodraht (901) , der einen Source-Bereich (902) , einen Kanalbereich (903) und einen Drain-Bereich (904) des Feldeffekttransistors (900) bildet,
• mit mindestens einer auf dem Nanodraht (901) aufgebrachten elektrisch isolierenden Nanoröhre (905) , die einen Isolator des Feldeffekttransistors (900) bildet,
• mit mindestens einer auf der isolierenden Nanoröhre (905) aufgebrachten elektrisch halbleitenden oder metallisch leitenden Nanoröhre (906) , die einen Gate-Bereich des Feldeffekttransistors (900) bildet.

14. Feldeffekttransistor (700) nach Anspruch 12 oder 13, bei dem der Nanodraht (701) ein Silizium-Nanodraht ist.

15. Feldeffekttransistor (700) nach Anspruch 12 oder 13, bei dem der Nanodraht (701) eine weitere Nanoröhre (701) ist.

16. Feldeffekttransistor (700) nach Anspruch 15, bei dem die weitere Nanoröhre (701) eine weitere Kohlenstoff-Nanoröhre ist.

17. Feldeffekttransistor (800) nach Anspruch 15 oder 16,
bei dem die weitere Nanoröhre (801) mindestens einen halbleitenden Bereich (803) aufweist sowie mindestens einen metallisch leitenden Bereich (802).

18. Feldeffekttransistor (800) nach Anspruch 17, bei dem der halbleitende Bereich (803) zwischen zwei metallisch leitenden Bereichen (802, 804) angeordnet ist.

19. Feldeffekttransistor (700) nach einem der Ansprüche 12 bis 18, bei dem der isolierende Bereich (708) der Nanoröhre eine Bor-Nitrid-Nanoröhre ist.

20. Feldeffekttransistor (800) nach einem der Ansprüche 12 bis 19, bei dem der halbleitende Bereich (803) oder der metallisch leitende Bereich (802) der Nanoröhre (801) eine Kohlenstoff-Nanoröhre ist.

21. Feldeffekttransistor (900) nach einem der Ansprüche 13 bis 18, bei dem die elektrisch isolierende Nanoröhre (905) eine Bor-Nitrid-Nanoröhre ist.

22. Feldeffekttransistor (800) nach einem der Ansprüche 13 bis 18, bei dem die halbleitende (803) oder die metallisch leitende Nanoröhre (802) eine Kohlenstoff-Nanoröhre ist.

23. Feldeffekttransistor (700) nach einem der Ansprüche 12 bis 22, bei dem zumindest eine der Nanoröhren (701, 705) mehrere Wände aufweist.

## Claims

1. A field-effect transistor (100),
• having a nanowire (101), which forms a source region (102), a channel region (103) and a drain region (104) of the field-effect transistor (100), the nanowire (101) being a semiconducting and/or metallically conductive nanowire,
• having at least one nanotube (106), which forms a gate region of the field-effect transistor, the nanotube being a semiconducting and/or metallically conductive nanotube,
• one end of the nanotube (106) being arranged close to the nanowire (101) in such a manner that the conductivity of the channel region (103) of the nanowire (101) can be controlled by said one end by means of a field effect as a result of an electric voltage being applied to the nanotube (106).

2. The field-effect transistor (100) as claimed in claim 1,
• in which the nanowire (101) is formed by a first nanotube (101) and
• in which the nanotube is formed by a second nanotube.

3. The field-effect transistor (100) as claimed in claim 2, in which the first nanotube (101) and/or the second nanotube (106) is/are a carbon nanotube.

4. The field-effect transistor (100) as claimed in claims 1 to 3, in which electrically non-conductive gas is introduced between the nanowire (101) and the nanotube (106).

5. The field-effect transistor (100) as claimed in one of claims 2 to 4, in which the first nanotube (101) and/or the second nanotube (106) has a plurality of walls.

6. The field-effect transistor (100) as claimed in one of claims 2 to 5,
• in which an insulator layer (105) is applied at least to the channel region (103) of the first nanotube (101), and
• in which the second nanotube is applied to the insulator layer (105).

7. The field-effect transistor (100) as claimed in claim 6, in which the insulator layer (105) contains an oxide material or a nitride material.

8. The field-effect transistor (400) as claimed in one of claims 1 to 7, in which the nanotube (407) which forms the gate region of the field-effect transistor (400) has three ends, it being possible for an electric voltage to be applied to one end, and the two further ends being arranged in such a manner that, as a result of the applied electric voltage, they can be used to change the conductivity of the channel region (403, 404, 405) of the nanowire.

9. The field-effect transistor (500) as claimed in one of claims 1 to 8,
• in which a third nanotube (502) is provided, which forms a second gate region of the field-effect transistor (500), the third nanotube (502) being a semiconducting and/or metallically conductive nanotube, and
• one end of the nanotube (502) being arranged close to the nanowire (201) in such a manner that the conductivity of the channel region (203) of the nanowire (201) can be controlled by said one end of the nanotube (502) by means of a field effect as a result of an electric voltage being applied to the third nanotube (502).

10. The field-effect transistor (500) as claimed in one of claims 1 to 9, in which the nanotube (106) which forms the gate region of the field-effect transistor and the third nanotube (502) are electrically coupled to one another.

11. The field-effect transistor (600) as claimed in one of claims 1 to 10, in which at least one of the nanotubes (601) includes a multiplicity of nanotubes.

12. The field-effect transistor (700) as claimed in claim 1,
• in which the at least one nanotube (705) is applied to the nanowire (701) and includes an electrically insulating region (708) and a semiconducting region (709) or a metallically conductive region (709),
• the insulating region (708) of the nanotube (705) being applied to the channel region (703) of the nanowire (701) in such a manner that the insulating region (708) of the nanotube forms an insulator of the field-effect transistor (700) and,
• that the semiconducting region (709) or the metallically conductive region (709) of the nanotube (705) forms a gate region of the field-effect transistor (700).

13. The field-effect transistor (900) as claimed in claim 12,
• having a nanowire (901), which forms a source region (902), a channel region (903) and a drain region (904) of the field-effect transistor (900),
• having at least one electrically insulating nanotube (905) which is applied to the nanowire (901) and forms an insulator of the field-effect transistor (900),
• having at least one electrically semiconducting or metallically conductive nanotube (906) which is applied to the insulating nanotube (905) and forms a gate region of the field-effect transistor (900).

14. The field-effect transistor (700) as claimed in claim 12 or 13, in which the nanowire (701) is a silicon nanowire.

15. The field-effect transistor (700) as claimed in claim 12 or 13, in which the nanowire (701) is a further nanotube (701).

16. The field-effect transistor (700) as claimed in claim 15, in which the further nanotube (701) is a further carbon nanotube.

17. The field-effect transistor (800) as claimed in claim 15 or 16, in which the further nanotube (801) includes at least one semiconducting region (803) and at least one metallically conductive region (802).

18. The field-effect transistor (800) as claimed in claim 17, in which the semiconducting region (803) is arranged between two metallically conductive regions (802, 804) .

19. The field-effect transistor (700) as claimed in one of claims 12 to 18, in which the insulating region (708) of the nanotube is a boron nitride nanotube.

20. The field-effect transistor (800) as claimed in one of claims 12 to 19, in which the semiconducting region (803) or the metallically conductive region (802) of the nanotube (801) is a carbon nanotube.

21. The field-effect transistor (900) as claimed in one of claims 13 to 18, in which the electrically insulating nanotube (905) is a boron nitride nanotube.

22. The field-effect transistor (800) as claimed in one of claims 13 to 18, in which the semiconducting (803) or metallically conductive nanotube (802) is a carbon nanotube.

23. The field-effect transistor (700) as claimed in one of claims 12 to 22, in which at least one of the nanotubes (701, 705) includes a plurality of walls.

## Revendications

1. Transistor (100) à effet de champ,
• comprenant un nanofil (101) qui forme une zone (102) de source, une zone (103) de canal et une zone (104) de drain du transistor (100) à effet de champ, le nanofil (101) étant un nanofil semi-conducteur et/ou un nanofil conducteur métalliquement,
• comprenant au moins un nanotube (106) qui forme une zone de grille du transistor à effet de champ, le nanotube étant un nanotube semi-conducteur et/ou un nanotube conducteur métalliquement,
dans lequel
• une extrémité du nanotube (106) est disposée près du nanofil (101), de sorte que, par cette une extrémité, la conductivité de la zone (103) de canal du nanofil (101) peut être commandée au moyen d'un effet de champ par application d'une tension électrique au nanotube (106).

2. Transistor (100) à effet de champ suivant la revendication 1,
• dans lequel le nanofil (101) est formé d'un premier nanotube (101), et
• dans lequel le nanotube est formé d'un deuxième nanotube.

3. Transistor (100) à effet de champ suivant la revendication 2, dans lequel le premier nanotube (101) et/ou le deuxième nanotube (106) est/sont un nanotube en carbone.

4. Transistor (100) à effet de champ suivant l'une des revendication 1 à 3,
dans lequel un gaz non conducteur de l'électricité est introduit entre le nanofil (101) et le nanotube (106).

5. Transistor (100) à effet de champ suivant l'une des revendications 2 à 4, dans lequel le premier nanotube (101) et/ou le deuxième nanotube (106) ont plusieurs parois.

6. Transistor (100) à effet de champ suivant l'une des revendications 2 à 5,
dans lequel une couche (105) isolante est déposée au moins sur la zone (103) de canal du premier nanotube (101), et
dans lequel le deuxième nanotube est déposé sur la couche (105) isolante.

7. Transistor (100) à effet de champ suivant la revendication 6, dans lequel la couche (105) isolante contient un oxyde ou un nitrure.

8. Transistor (400) à effet de champ suivant l'une des revendications 1 à 7, dans lequel le nanofil (407) formant la zone de grille du transistor (400) à effet de champ a trois extrémités, une tension électrique pouvant être appliquée à une extrémité et les deux autres extrémités étant disposées de façon à ce que la conductivité de la zone (403, 404, 405) de canal du nanofil puisse être modifiée par eux en raison de la tension électrique appliquée.

9. Transistor (500) à effet de champ suivant l'une des revendications 1 à 8,
• dans lequel il est prévu un troisième nanotube (502) qui forme une deuxième zone de grille du transistor à effet de champ (500), le troisième nanotube (502) étant un nanotube semi-conducteur et/ou conducteur métalliquement, et
• dans lequel une extrémité du nanotube (502) étant disposé près du nanofil (201) de sorte que par cette extrémité du nanotube (502), on peut se rendre maître au moyen d'un effet de champ par application d'une tension électrique au troisième nanotube (502) de la conductivité de la zone (203) de canal du nanofil (201).

10. Transistor (500) à effet de champ suivant l'une des revendications 1 à 9, dans lequel le nanotube (106) formant la zone de grille du transistor à effet de champ et le troisième nanotube (502) sont couplés électriquement entre elles.

11. Transistor (600) à effet de champ suivant l'une des revendications 1 à 10,
dans lequel au moins l'un des nanotubes (601) a une pluralité de nanotubes.

12. Transistor (700) à effet de champ suivant la revendication 1,
• dans lequel le au moins un nanotube (705) est déposé sur le nanofil (701) et a une partie (708) isolante du point de vue électrique et une partie (709) semi-conductrice ou une partie (709) conductrice métalliquement.
• dans lequel la partie (708) isolante du nanotube (705) est déposée sur la zone (703) de canal du nanofil (701) de façon à ce que la zone (708) isolante du nanotube forme un isolant du transistor (700) à effet de champ et
• en ce que la partie (709) semi-conductrice et la partie (709) conductrice métalliquement du nanotube (705) forme une zone de grille du transistor (700) à effet de champ.

13. Transistor (900) à effet de champ suivant la revendication 12,
• comprenant un nanofil (901), une zone (902) de source, une zone (903) de canal et une zone (904) de drain du transistor (900) à effet de champ,
• comprenant au moins un nanotube (905) isolant électriquement déposé sur le nanofil (901) et formant un isolant du transistor (900) à effet de champ,
• comprenant au moins un nanotube (906) déposé sur le nanotube (905) isolant, semi-conducteur ou conducteur métalliquement du point de vue électrique et formant une zone de grille du transistor (900) à effet de champ.

14. Transistor (700) à effet de champ suivant la revendication 12 ou 13, dans lequel le nanofil (701) est un nanofil en silicium.

15. Transistor (700) à effet de champ suivant la revendication 12 ou 13, dans lequel le nanofil (701) est un autre nanotube (701).

16. Transistor (700) à effet de champ suivant la revendication 15, dans lequel l'autre nanotube (701) est un autre nanotube en carbone.

17. Transistor (800) à effet de champ suivant la revendication 15 ou 16, dans lequel l'autre nanotube (801) a au moins une zone (803) semi-conductrice, ainsi qu'au moins une zone (802) conductrice métalliquement.

18. Transistor (800) à effet de champ suivant la revendication 17, dans lequel la zone (803) semi-conductrice est disposée entre deux zones (802, 804) conductrices métalliquement.

19. Transistor (700) à effet de champ suivant l'une des revendications 12 à 18, dans lequel la zone (708) isolante du nanotube est un nanotube au nitrure de bore.

20. Transistor (800) à effet de champ suivant l'une des revendications 12 à 19, dans lequel la zone (803) semi-conductrice ou la zone (802) conductrice métalliquement du nanotube (801) est un nanotube en carbone.

21. Transistor (900) à effet de champ suivant l'une des revendications 13 à 18, dans lequel le nanotube (905) isolant électriquement est un nanotube en nitrure de bore.

22. Transistor (800) à effet de champ suivant l'une des revendications 13 à 18, dans lequel le nanotube semi-conducteur (803) ou conducteur métalliquement (802) est un nanotube en carbone.

23. Transistor (700) à effet de champ suivant l'une des revendications 12 à 22, dans lequel au moins l'un des nanotubes (701, 705) a plusieurs parois.
